Europäisches Patentamt

European Patent Office

Office européen des brevets

(19)

(11) Publication number: **0 326 154**
**A2**

# EUROPEAN PATENT APPLICATION

(12)

(21) Application number: **89101438.3**

(51) Int. Cl.4: **G11C 7/00 , G11C 11/44**

(22) Date of filing: **27.01.89**

(30) Priority: **27.01.88 JP 16568/88**

(43) Date of publication of application:
**02.08.89 Bulletin 89/31**

(84) Designated Contracting States:
**DE FR**

(71) Applicant: **NEC HOME ELECTRONICS, LTD.**
**5-24, Miyahara 3-chome Yodogawa-ku**
**Osaka-Shi Osaka(JP)**

(72) Inventor: **Ito, Susumu c/o NEC Home**
**Electronics Ltd.**
**No. 5-24, Miyahara 3-chome Yodogawa-ku**
**Osaka-shi Osaka(JP)**

(74) Representative: **Diehl, Hermann Dr. et al**
**Diehl & Glaeser, Hiltl & Partner**
**Flüggenstrasse 13**
**D-8000 München 19(DE)**

(54) **Memory device.**

(57) A memory device comprises first striped electrodes ($2_1$, $2_2$, ...) and second striped electrodes ($4_1$, $4_2$, ...) arranged so as to intersect and be insulated from each other, superconducting rings ($8_{11}$ $8_{12}$, ...) each disposed in a region ($6_{11}$, $6_{12}$, ...) surrounded by the first and second electrodes ($2_1$, $2_2$, ... $4_1$, $4_2$, ...), superconduction control means (103) for changing an electric conduction type of selected ones of the superconducting rings ($8_{11}$, $8_{12}$,...) to the ordinary conduction or to the superconduction, a write circuit (10) for providing signal currents to the first ($2_1$, $2_2$, ...) and second ($4_1$, $4_2$, ...) striped electrodes surrounding the selected superconducting rings ($8_{11}$, $8_{12}$, ...) in synchronism with an operation of the superconduction control means (103) so that information data can be stored in the selected rings as permanent currents, and a read circuit (10) for detecting induction currents generated in the first ($2_1$, $2_2$, ...) and second ($4_1$, $4_2$, ...) striped electrodes surrounding selected ones of the superconducting rings ($8_{11}$, $8_{12}$, ...) when the electric conduction of the selected rings ($8_{11}$, $8_{12}$, ...) are changed to the ordinary conduction.

FIG. 1

## MEMORY DEVICE

The present invention relates to a memory device. The invention, more particularly, is in the field of a memory device composed of high density memory elements with use of a superconducting material.

There are known memory devices constructed with use of a superconducting material, one of which is disclosed in Japanese Patent Application Unexamined Publication No. 153897/1986. Such a memory device includes intersecting first striped superconductors which are insulated from each other and disposed on one surface of a magnetic recording medium, second striped superconductors for generating bias pulse magnetic fields which are disposed on the other surface of the magnetic recording medium, and striped magnetoresistance elements disposed so as to intersect the second striped superconductors.

Such a prior art memory device is adapted to store information on the magnetic recording medium with use of magnetic fields generated at intersections of the first striped superconductors provided on one surface of the magnetic recording medium, and read the stored information with use of the second striped superconductors and the magnetoresistance elements. This type of memory device has high mechanical durability because it does not require a rotational magnetic disk and a moving write/read head.

However, the above memory device requires special materials such as the superconductors and the magnetoresistance elements, and the magnetic recording medium, and also a variety of materials are employed to construct the memory device. Additionally, the memory device stores information in a binary format.

In view of the problems of the prior art techniques, an object of the present invention is to provide a high density memory device with reduced kinds of materials. This object is achieved by the memory device of claim 1. Further advantageous features of this memory device according to the present invention are evident from the dependent claims.

The invention therefore provides a memory device which comprises:
a substrate;
striped electrodes disposed on the substrate so as to intersect each other in a matrix configuration;
superconducting rings, each disposed in a region surrounded by the striped electrodes, superconduction control means for converting a state of electrical conduction of each superconducting ring to ordinary conduction or to superconduction, a write circuit means for selectively providing signal currents to the striped electrodes in synchronism with an operation of the superconduction control means so as to generate permanent currents in the superconducting rings; and a read circuit means for detecting induction currents generated in the striped electrodes when the superconduction states of selected ones of the superconducting rings are broken by means of the superconduction control means; wherein information is stored in the form of the permanent current flowing through the superconducting ring with three storage states determined by magnitude and a direction of the permanent current.

In accordance with the present invention arranged as described above, read and write operations are executed as follows.

### Write Operation

The superconduction control means breaks the superconduction states of the superconducting rings into which information data are going to be written, and write/read means provides the predetermined signals to the striped electrodes surrounding the superconducting rings. Hereby, the superconducting ring not in the superconduction state is exposed to a magnetic field generated by the signal currents flowing through the striped electrodes (thereupon, an induced current flows through the superconducting ring not in the superconduction state but it attenuates at once because of its finite resistance). In this situation, the superconduction control means restores the superconduction state of the superconducting ring and, at the same time, stops providing the signals to the striped electrodes. Thereby, an induction current is generated in the superconducting ring which has recovered its superconduction state so as to prevent the magnetic field from disappearing, which current keeps on flowing through the superconducting ring (permanent current).

Information is thus stored in the superconducting ring with three states specified by the magnitude and flowing direction of the permanent current: that is, a state where the current flow clockwise, a state where the current flows counterclockwise, and a remaining state where the both currents are existent to apparently result in a no-current state. This assures storage of plenty of information.

### Read Operation

In the meantime, the information stored as described above in the superconducting ring is read out by permitting the superconduction control means to break the superconduction state of the superconducting ring. Hereby, the permanent current flowing through the superconducting ring is extinguished. Thereupon, the magnetic field being produced by the permanent current is also extinguished. Electromotive forces are generated in the striped electrodes disposed around the superconducting ring so as to cancel the change in the magnetic field. The write/read means detects the induced electromotive forces and outputs the same thus detected as information.

In accordance with the present invention arranged as described above, a high density memory device can be constructed with reduced kinds of materials, where information data are stored with the three storage states.

Other and further objects, features and advantages of the invention will appear more fully from the following description taken in connection with the accompanying drawings.

Fig. 1 is a view illustrating the arrangement of a memory device according to the first embodiment of the present invention;

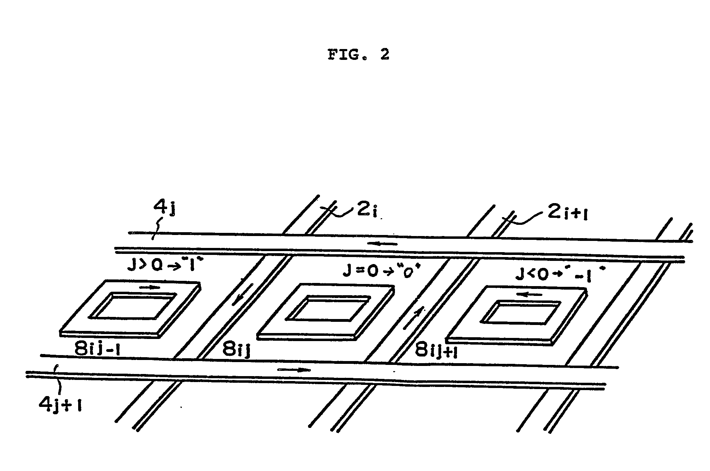

Fig. 2 is a view illustrating the mode of information storage of the first embodiment;

Fig. 3 is a view illustrating the arrangement of the second embodiment;

Fig. 4 is a view illustrating the arrangement of the third embodiment; and

Fig. 5 is a view illustrating the arrangement of a fourth embodiment.

In what follows, embodiments of the present invention will be described with reference to the drawings.

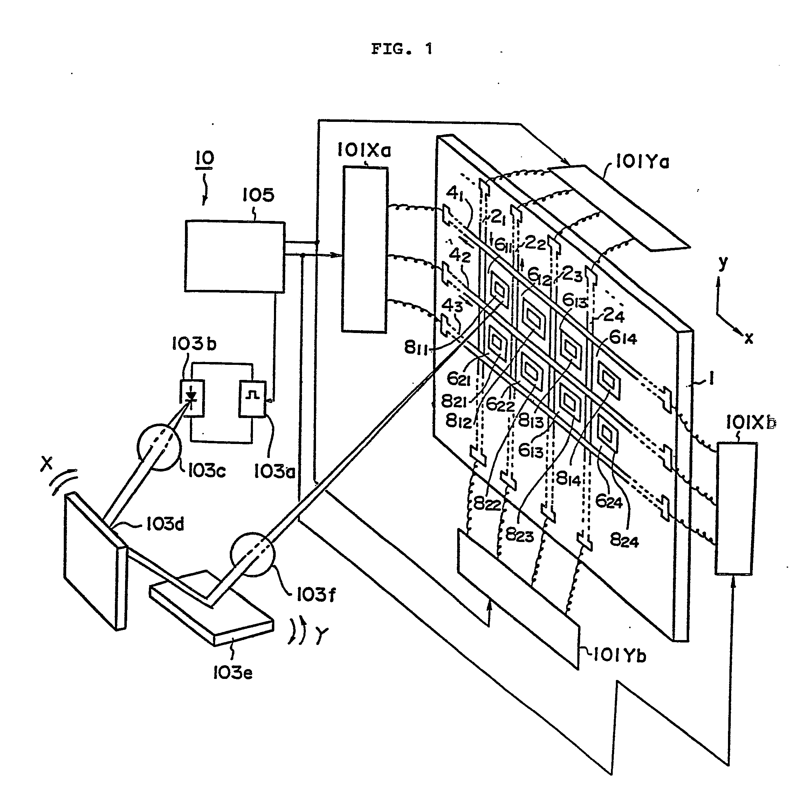

Fig. 1 shows a memory device according to the first embodiment of the present invention.

The memory device of Fig. 1 includes striped electrodes $2_1$, $2_2$, $2_3$, ... and striped electrodes $4_1$, $4_2$, $4_3$, ... intersecting the former electrodes, the two groups of the electrodes being insulated from each other and disposed on a substrate 1 such as ceramic. The memory device further includes superconducting rings $8_{11}$, $8_{12}$, $8_{13}$, ... made of a superconducting material of for example an yttrium group (Y-Ba-Cu-O), which are disposed in respective regions $6_{11}$, $6_{12}$, $6_{13}$, ... being surrounded by the electrodes $2_1$, $2_2$, $2_3$, ..., $4_1$, $4_2$, $4_3$, ... . And, it further includes write/read means 10 for effecting write and read operation of information, which permits signals to be directed into the respective electrodes $2_1$, $2_2$, $2_3$, ..., $4_1$, $4_2$, $4_3$, ..., signals induced in the respective electrodes $2_1$, $2_2$, $2_3$, ..., $4_1$, $4_2$, $4_3$, ... to be detected, and superconduction states of the superconducting rings $8_{11}$, $8_{12}$, $8_{13}$, ...

to be temporarily broken.

The write/read means 10 includes a control/detection circuit 101 for making signals flow into the respective electrodes $2_1$, $2_2$, $2_3$, ..., $4_1$, $4_2$, $4_3$, ... and detecting signals induced in the respective electrodes $2_1$, $2_2$, $2_3$, ..., $4_1$, $4_2$, $4_3$, ...; superconduction control means 103 for temporarily breaking the superconduction states of the superconducting rings $8_{11}$, $8_{12}$, $8_{13}$, ...; and a controller 105 for controlling write/read operation through controlling the control/detection circuit 101 and the superconduction control means 103.

The control/detection circuit 101 includes circuits 101Xa and 101Xb connected to respective ends of each of the striped electrodes $2_1$, $2_2$, $2_3$, ..., and circuits 101Ya and 101Yb connected to respective ends of each of the Striped electrodes $4_1$, $4_2$, $4_3$, ... . The superconduction control means 103 includes a pulse generator 103a controlled by the controller 105, a laser diode 103b for emitting laser light being driven by the pulse generator 103a, lenses 103c and 103f for focusing the laser light from the laser diode 103b on to the superconducting rings $8_{11}$, $8_{12}$, $8_{13}$, ..., an X-direction scanning mirror 103d for scanning the laser light in the X direction under the control of the controller 105, a Y-direction scanning mirror 103e for scanning in the Y direction the laser light which has been scanned by the X-direction scanning mirror 103d under the control of the controller 105. The superconducting rings 811, 812, $81_3$,... are selectively heated by the laser light so that their conduction states are changed to the ordinary conduction. The controller 105 is adapted to control the above described constituent members in conformity with instructions, write/read data, etc. from an external processing device.

Here, the superconducting rings $8_{11}$, $8_{12}$, $8_{13}$, ... are, when constructed with for example an yttrium group (Y-Ba-Cu-)) superconducting material, cooled by a cooling liquid such as liquid helium, liquid nitrogen, etc. Such cooling is not required, as a matter of course, for room-temperature superconducting materials.

In succession, operation of the first embodiment arranged as such will be described.

Write Operation

With an assumption that a superconducting ring of interest $8_{ij}$ (i, j: arbitrary integer) is, for example, the superconducting ring $8_{11}$ as illustrated in Fig. 1, the laser light from the superconduction control means 103 breaks its superconduction state, and the control/detection circuit 101 of the write/read means 10 provides predetermined signals to the striped electrodes $2_1$, $2_2$, $4_1$, $4_2$

surrounding the superconducting ring Thereupon, the superconducting ring $8_{11}$ which is not in the superconduction state is exposed to a magnetic field generated by the signal currents flowing through the striped electrodes $2_1$, $2_2$, $4_1$, $4_2$. In this situation, the superconduction control means 103 restores the superconduction state of the superconducting ring 811 by stopping providing the laser light thereto, and, at the same time, the control/detection circuit 101 stops providing the signals to the striped electrodes $2_1$, $2_2$, $4_1$, $4_2$. This generates an induction current through the superconducting ring $8_{11}$ to prevent the magnetic field from disappearing, which current keeps on flowing through the superconducting ring $8_{11}$ (permanent current). Hereby, necessary information is stored.

Plenty of information can be recorded by performing the above write operation with respect to the predetermined superconducting rings $8_{ij}$; that is, under the control of the controller 105, permitting the control/detection circuit 101 to control the signal currents directed to the electrodes 2, 4, and also permitting the superconduction control means 103 to scan the superconducting rings 8 with the laser light.

Read Operation

On the other hand, the information stored in the superconducting rings $8_{11}$, $8_{12}$, $8_{13}$ ... as described above is read out as follows. Also here, a case will be described wherein the data stored in the superconducting ring $8_{11}$ is read out. The superconduction control means 103 changes the state of the superconducting ring $8_{11}$ from the ordinary conduction to the non-superconduction. Thereupon, the permanent current which has been flowing through the superconducting ring $8_{11}$ is extinguished. Electromotive forces are induced on the striped electrodes $2_1$, $2_2$, $4_1$, $4_2$ surrounding the superconducting ring 811 owing to a change in the magnetic field at that time. The control/detection circuit 101 of the write/read means 10 detects the induced electromotive forces and outputs those as information. Plenty of information can thus be read out by, under the control of the controller 105, permitting the control/detection circuit 101 to detect the induced electromotive forces generated in the electrodes 2, 4, and also permitting the superconduction control means 103 to scan the superconducting rings 8 with the laser light.

It should be noted that in this first embodiment the information can be stored with three values utilizing a flowing direction and magnitude of the permanent current through the superconducting ring $8_{ij}$.

The present embodiment may thus employ a superconducting material only for the superconducting rings $8_{ij}$, and can provide a high density memory device consisting of few kinds of materials, and can permit information to be stored with three storage states.

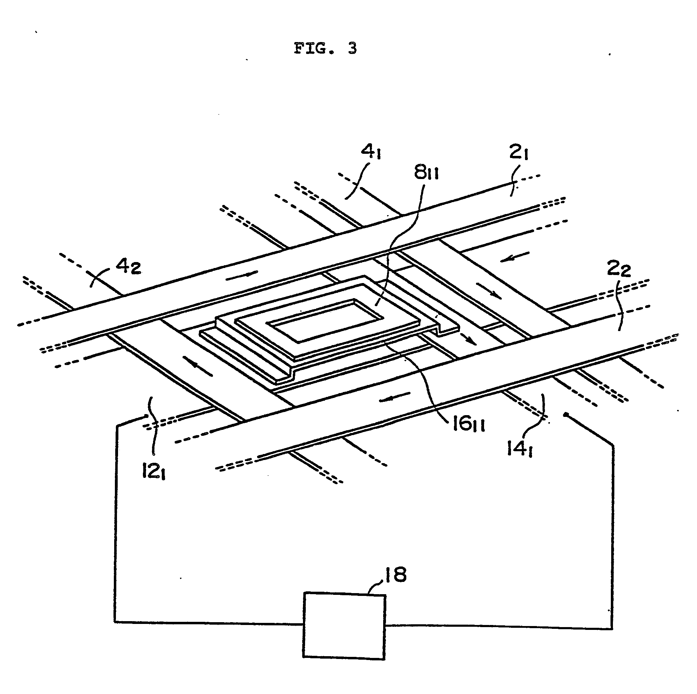

Referring to Fig. 3, the second embodiment is illustrated in a perspective view, enlarged in part.

The second embodiment of Fig. 3 is different from the first embodiment in that the superconduction control means $103'$ is constructed as described below and mounting of the superconducting rings $8_{11}$, $8_{12}$, $8_{13}$, ... is modified. That is, the superconduction control means $103'$ further comprises: striped electrodes $12_1$, $12_2$, $13_3$, ... disposed between adjacent ones of the striped electrodes $2_1$, $2_2$, $2_3$, ...; striped electrodes $14_1$, $14_2$, $14_3$ ... disposed in parallel to the striped electrodes $4_1$, $4_3$, $4_5$, ...; intersecting the above electrodes $12_1$, $12_2$, $12_3$, ...; heaters $16_{11}$, $16_{12}$, $16_{13}$, ... disposed at intersections of the electrodes ($12_1$, $14_1$), ($12_2$, $14_2$], ($12_3$, $14_3$), each heater contacting with the pair of intersecting electrodes; and a control circuit 18 for selectively activating or stopping activating the heaters $16_{11}$, $16_{12}$, $16_{13}$, ... . The superconducting rings $8_{11}$, $8_{12}$, $8_{13}$, ... are mounted on the respective heaters $16_{11}$, $16_{12}$, $16_{13}$, ..., as illustrated in Fig. 3.

Operation of the second embodiment arranged as such will be described.

Write Operation

With the assumption that a superconducting ring of interest $8_{ij}$ (i, j; arbitrary integer) is, for example, the superconducting ring $8_{11}$ as illustrated in Fig. 3, the heater $16_{11}$ of the superconduction control means 103 of the write/read means 10 breaks the superconduction state of the superconducting ring $8_{11}$ by forcing the heater $16_{11}$ to heat with use of the control circuit 18. And, the control/detection circuit 101 provides predetermined signals to the striped electrodes $2_1$, $2_2$, $4_1$, $4_2$ surrounding the superconducting ring $8_{11}$. Thereupon, the superconducting ring $8_{11}$ which is not in the superconduction state is exposed to a magnetic field produced by signal currents flowing through the striped electrodes $2_1$, $2_2$, $4_1$, $4_2$. In this situation, the control circuit 18 forces the heater $16_{11}$ to finish its heating state, whereby the superconducting ring $8_{11}$ which has been in the non-superconduction state is changed to have the superconduction state. And, at the same time, the control/detection circuit 101 stops providing the signals to the striped electrodes $2_1$, $2_2$, $4_1$, $4_2$. Hereby, in the superconducting ring $8_{11}$ an induction current is generated so as to prevent the magnetic field from disappearing, which current keeps on flowing through the superconducting ring $8_{11}$ (permanent current). This allows necessary information to be stored.

Thus, plenty of information can be recorded by performing the above recording operation with respect to the predetermined superconducting rings $8_{ij}$; that is, under the control of the controller 105, permitting the control/detection circuit 101 to control the signal currents flowing through the electrodes 2, 4 and also permitting the superconduction control means $103'$ to selectively activate or stop activating the heaters 16.

## Read Operation

In the meantime, the information stored in the superconducting rings $8_{11}$, $8_{12}$, $8_{13}$, ... as described above is read out as follows. Also in the present description, a case will be described wherein the data stored in the superconducting ring $8_{11}$ is read out. The heater $16_{11}$ of the superconduction control means $103'$ is forced to heat by operation of the control circuit 18 so that the superconducting ring $8_{11}$ is changed to have the non-superconduction state. Thereupon, the permanent current flowing through the superconducting ring $8_{11}$ is extinguished. A change in the magnetic field at that time causes eleotromotive forces to be induced in the striped electrodes $2_1$, $2_2$, $4_1$, $4_2$ surrounding the superconducting ring $8_{11}$. The control/detection circuit 101 of the write/read means 10 detects the above induced electromotive forces and outputs those as information. Plenty of information can thus be read out by performing above read operation with respect to the predetermined superconducting rings $8_{ij}$; that is, under the control of the controller 105, permitting the control/detection circuit 101 to detect the electromotive forces induced in the striped electrodes 2, 4 and also permitting the superconduction control means $103'$ to selectively activate the heaters 16.

It should here be noted that in the second embodiment information can be stored with three values utilizing a flowing direction and magnitude of the permanent current through the superconducting ring 8.

In accordance with the second embodiment, only the superconducting ring $8_{ij}$ may be constructed with a superconducting material, and consequently a high density memory device can be constructed with few materials. Information can be stored with three values. Additionally, no mechanical portion is required for scanning the laser light, assuring mechanical durability.

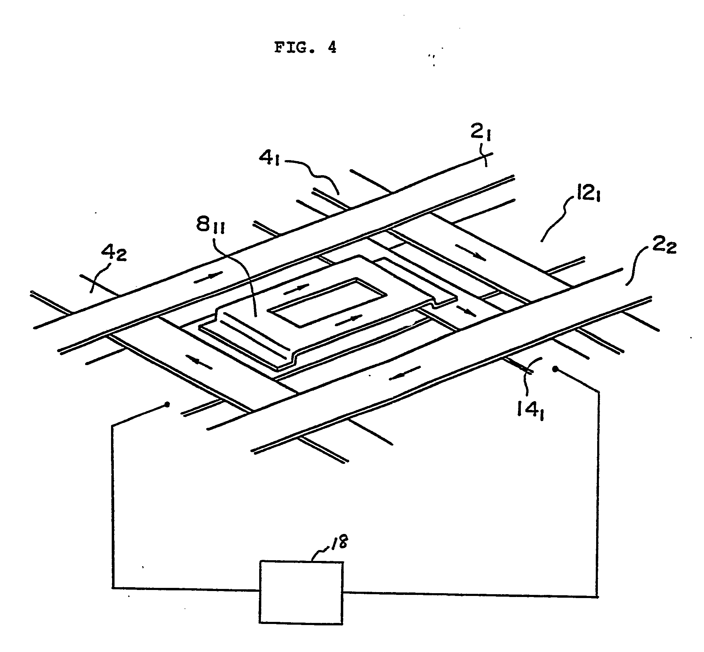

Referring here to Fig. 4, the third embodiment of the present invention is illustrated in a perspective view, enlarged in part.

The third embodiment of Fig. 4 is different from the previous second embodiment only in that the superconduction control means $103''$ is arranged so as to directly connect the superconducting rings $8_{11}$, $8_{12}$, $8_{13}$, ... to the respective pairs of electrodes $(12_1, 14_1)$, $(12_2, 14_2)$, $(12_3, 14_3)$, ... at the intersecting positions. Other arrangements are the same as those in the previous second embodiment. The same symbols shall accordingly be applied to the same portions as those in the second embodiment, and the description thereof will be omitted.

Operation of the third embodiment arranged as such will be described.

## Write Operation

A superconducting ring of interest $8_{ij}$ (i, j: arbitrary integer) is assumed to be, for example, the superconducting ring $8_{11}$ as illustrated in Fig. 4. The control means $103''$ breaks the superconduction state of the superconducting ring $8_{11}$ by selecting the electrodes $12_1$, $14_1$ to permit a current larger than the critical current value to flow through the superconducting ring $8_{11}$. And, the control/detection circuit 101 of the write/read means 10 provides predetermined signals to the striped electrodes $2_1$, $2_2$, $4_1$, $4_2$ surrounding the superconducting ring $8_{11}$. Thereupon, the superconducting ring $8_{11}$ which is not in the superconduction state is exposed to a magnetic field generated by the signal currents flowing through the striped electrodes $2_1$, $2_2$, $4_1$, $4_2$. In this situation, the control circuit 18 of the superconduction control means $103''$ restores the superconduction state of the superconducting ring $8_{11}$ by stopping providing the current larger than the critical current to the superconducting ring $8_{11}$, and at the same time lhe control/detection circuit 101 stops providing the signals to the striped electrodes $2_1$, $2_2$, $4_1$, $4_2$. Hereby, in the superconducting ring $8_{11}$ an induction current is generated so as to prevent the above magnetic field from disappearing, which current keeps on flowing through the superconducting ring $8_{11}$ (permanent current). Accordingly, necessary information is stored.

Plenty of information can thus be recorded by performing the above recording operation with respect to the predetermined superconducting rings $8_{ij}$; that is, under the control of the controller 105, permitting the control/detection circuit 101 to control the signal currents flowing through the electrodes 2, 4 and also permitting the superconduction control means $103''$ to select the superconducting rings 8 through which the currents larger than the critical current are to flow.

## Read Operation

In the meantime, the information stored in the superconducting rings $8_{11}$, $8_{12}$, $8_{13}$, ... as described above is read out as follows. Also in the present description, a case will be described where the data stored in the superconducting ring $8_{11}$ is read-out. The superconducting ring $8_{11}$ is made to have the non-superconduction state by permitting the circuit 18 of the superconduction control means $103''$ to select the electrodes $12_1$, $14_1$ for forcing a current larger than the critical current to flow through the superconducting ring $8_{11}$. Thereupon, the permanent Current flowing through the superconducting ring $8_{11}$ is extinguished. A change in the magnetic field caused thereupon induce electromotive forces in the striped electrodes $2_1$, $2_2$, $4_1$, $4_2$ surrounding the superconducting ring $8_{11}$. The control/detection circuit 101 of the write/read means 10 detects the induced electromotive forces and outputs those as information. Plenty of information can be recorded by performing the above read operation with respect to the predetermined superconducting rings $8_{ij}$; that is, under the control of the controller 105, permitting the control/detection circuit 101 to detect the electromotive forces induced in the striped electrodes 2, 4 and also permitting the superconduction control means $103''$ to selectively force the currents larger than the critical current to flow through the superconducting rings 8.

In accordance with the third embodiment, only the superconducting ring $8_{ij}$ may be constructed with a supercon.ducting material, and consequently a high density memory device can be constructed with few kinds of materials. Additionally, this embodiment can present other features of storing information with three values and having no mechanical portion for scanning, the laser light to thereby assure high mechanical durability.

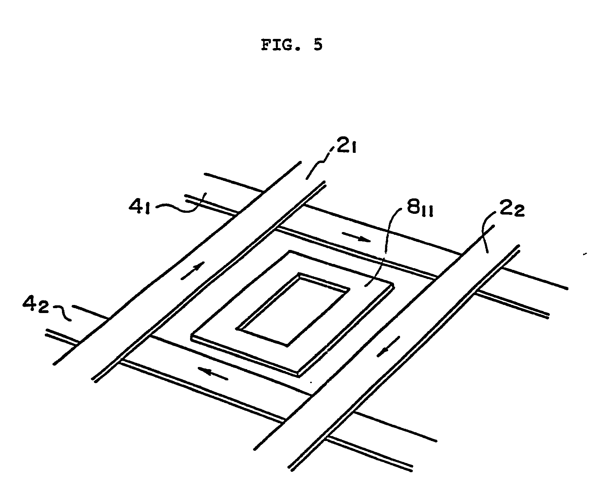

Referring further to Fig. 5, the fourth embodiment of the present invention is illustrated.

The fourth embodiment is different from the first one in the recording method and employs the same read means as those in the first or second embodiment. In accordance with the fourth embodiment, write means includes striped electrodes $2_1$, $2_2$, $2_3$, ... and striped electrodes $4_1$, $4_2$, $4_3$, ..., and controls the amount of currents flowing through these electrodes $2_1$, $2_2$, $2_3$, ..., $4_1$, $4_2$, $4_3$, ... .

Operation of the fourth embodiment arranged as such will be described.

## Write Operation

A superconducting ring of interest $8_{ij}$ (i, j; arbitrary integer) is assumed to be, for example, the superconducting ring $8_{11}$ as illustrated in Fig. 5. The superconduction state of the superconducting ring $8_{11}$ is broken when large currents are forced to flow through the striped. electrodes $2_1$, $2_2$, $4_1$, $4_2$ surrounding the superconducting ring $8_{11}$ so that a resultant magnetic field of the fields produced around the electrodes $2_1$, $2_2$, $4_1$, $4_2$ may exceed the critical magnetic field of the superconducting ring $8_{11}$ and be applied to the superconducting ring $8_{11}$. In succession, the large currents flowing through the electrodes $2_1$, $2_2$, $4_1$, $4_2$ are stopped. Thereupon, the superconducting ring $8_{11}$ retrieves its superconduction state, through which ring a permanent current flows simultaneously so as to prevent the magnetic field which have been produced by the currents flowing through the electrodes $2_1$, $2_2$, $4_1$, $4_2$ from disappearing.

Plenty of information can thus be recorded by performing the above recording operation with respect to the predetermined superconducting rings $8_{ij}$; that is, under the control of the controller 105, permitting the control/detection circuit 101 to selectively force the large currents to flow through the electrodes 2, 4.

## Read Operation

Read operation in the fourth embodiment may employ the read means described in the first and second embodiments.

In accordance with the present embodiment, superconducting rings $8_{ij}$ may be constructed with a superconducting material, and consequently a high density memory device can be constructed with few kinds materials. Information can be stored with three states. Furthermore, the write means can be simplified.

According to the present invention, as described above, a high density memory device can be constructed with few materials, information can be stored with three storage states, and memory capacity can be increased.

## Claims

1. A memory device, comprising:
a substrate (1);
first striped electrodes ($2_1$, $2_2$, ...) disposed in parallel on said substrate (1);
second striped electrodes ($4_1$, $4_2$, ...) disposed in parallel on said substrate (1) so as to intersect and be insulated from said first striped electrodes ($2_1$, $2_2$, ...);
superconducting rings ($8_{11}$, $8_{12}$, ...), each being disposed in a region ($6_{11}$, $6_{12}$, ...) surrounded by said first and second striped electrodes ($2_1$, $2_2$, ...;

$4_1$, $4_2$, ...);

superconduction control means (103, 103$'$, 103$''$) for changing an electric conduction type of selected ones of said superconducting rings ($8_{11}$, $8_{12}$, ...) to the ordinary conduction or to the superconduction;

write circuit means (10) for providing or stopping providing signal currents to first and second striped electrodes ($2_1$, $2_2$, ...; $4_1$, $4_2$, ...) surrounding first selected superconducting rings ($8_{11}$, $8_{12}$, ...) in synchronism with an operation of said superconduction control means (103, 103$'$, 103$''$) of changing the electric conduction type so that information data can be stored in said first selected superconducting rings ($8_{11}$, $8_{12}$, ...) as permanent currents; and

read circuit means (10) for detecting induction currents generated in first and second striped electrodes ($2_1$, $2_2$, $4_1$, $4_2$, ...) surrounding second selected superconducting rings ($8_{11}$, $8_{12}$, ...) when the electric conduction of said second selected superconduction rings are changed to the ordinary conduction.

2. A memory device as claimed in Claim 1, wherein said write circuit means (10) provides said signal currents while said first selected superconducting rings ($8_{11}$, $8_{12}$, ...) are made to be in the ordinary conduction by means of said superconduction control means (103, 103$'$, 103$''$), and then stops providing said signal currents when the electric conduction of said first selected superconducting rings ($8_{11}$, $8_{12}$, ...) are changed to the superconduction.

3. A memory device as claimed in Claim 1 or 2, wherein said information data are stored in said first selected superconducting rings ($8_{11}$, $8_{12}$, ...) in the form of said permanent currents with three storage states determined by magnitude and a direction of said permanent current.

4. A memory device as claimed in one of the preceding Claims, wherein said superconduction control means (103) comprises:

a laser source (103b) for emitting a pulsed laser beam, and

scanning means (103d, 103e) for scanning said superconducting rings ($8_{11}$, $8_{12}$, ...) with said pulsed laser beam; wherein

the electric conduction of said selected ones of said superconducting rings ($8_{11}$, $8_{12}$, ...) is changed when irradiated with said pulsed laser beam.

5. A memory device as claimed in one of Claims 1 to 3, wherein said superconduction control means (103$'$) comprises heaters ($16_{11}$, $16_{12}$, ...), each being associated with one of said superconducting rings ($8_{11}$, $8_{12}$, ...) ,wherein the electric conduction of said selected ones of said supercon-

ducting rings ($8_{11}$, $8_{12}$, ...) is changed by providing or stopping providing heat thereto from said heaters ($16_{11}$, $16_{12}$, ...).

6. A memory device as claimed in one of Claims 1 to 3, wherein said superconduction control means (103$''$) comprises current supplying means ($12_1$, $12_2$, ..., $14_1$, $14_2$, ...) for providing or stopping providing currents larger than the critical current to said selected ones of said superconducting rings ($8_{11}$, $8_{12}$, ...).

7. A memory device as claimed in Claim 1, wherein said superconduction control means (103) comprises magnetic field applying means for applying or stopping applying magnetic fields stronger than the critical magnetic field to said selected ones of said superconducting rings.

8. A memory device as claimed in Claim 7, wherein said superconduction control means (103) comprises said first ($2_1$, $2_2$, ...) and second ($4_1$, $4_2$, ...) striped electrodes.

N 4992-EP

FIG. 1

FIG. 2

FIG. 3

FIG. 4

EP 0 326 154 A2

FIG. 5